Europäisches Patentamt

**European Patent Office**

**Office européen des brevets**

(11) Veröffentlichungsnummer : **0 014 249**
**B1**

(12) **EUROPÄISCHE PATENTSCHRIFT**

(45) Veröffentlichungstag der Patentschrift :
**22.09.82**

(21) Anmeldenummer : **79105071.9**

(22) Anmeldetag : **10.12.79**

(51) Int. Cl.³ : **H 01 L 23/46, H 05 K  7/20**

(54) **Kühlvorrichtung zur Kühlung von elektrischen Bauelementen, insbesondere von integrierten Bausteinen.**

(30) Priorität : **31.01.79 DE 2903685**

(43) Veröffentlichungstag der Anmeldung :
**20.08.80 (Patentblatt 80/17)**

(45) Bekanntmachung des Hinweises auf die Patenterteilung : **22.09.82 Patentblatt 82/38**

(84) Benannte Vertragsstaaten :
**AT BE CH FR IT NL SE**

(56) Entgegenhaltungen :
**DE - A - 2 638 702**
**GB - A - 796 763**
**US - A - 3 668 506**
**US - A - 4 120 021**

(73) Patentinhaber : **SIEMENS AKTIENGESELLSCHAFT**
**Berlin und München**
**Postfach 22 02 61**
**D-8000 München 22 (DE)**

(72) Erfinder : **Richter, Hans-Jürgen, Dipl.-Ing.**
**Bert-Brecht-Strasse 9**
**D-8000 München 83 (DE)**
Erfinder : **Gräf, Hans**
**Memlingstrasse 6**
**D-8000 München 71 (DE)**
Erfinder : **Dinklage, Jörg-Ulrich**
**Putzbrunner Strasse 129**
**D-8000 München 83 (DE)**

Imprimerie Jouve, 18, rue St-Denis, 75001 Paris, France

EP 0 014 249 B1

# Kühlvorrichtung zur Kühlung von elektrischen Bauelementen, insbesondere von integrierten Bausteinen

Die Erfindung betrifft eine Kühlvorrichtung zur Kühlung von elektrischen Bauelementen, insbesondere von integrierten Bausteinen, die auf mit ihren Flachseiten nebeneinander angeordneten, vorzugsweise steckbaren Flachbaugruppen aufgebaut sind, mit einem flüssigen Kühlmittel, das durch dünnwandige Kunststoffbehälter geführt wird, die mit einer der Seitenwände an der zu kühlenden Flachbaugruppenoberfläche anliegen, wobei der Kreislauf außerhalb der Baueinheit zur Aufnahme der Flachbaugruppe über gemeinsame Sammelrohrleitungen, eine Pumpe, einen Kühler für die Rückkühlung des Kühlmittels und einem Vorratsbehälter geschlossen ist.

In der deutschen Patentschrift 2 638 702 wird bereits eine Kühlvorrichtung nach dem Oberbegriff beschrieben. Bei dieser Kühlvorrichtung sind zwischen den Flachbaugruppen dünnwandige, schmale, annähernd quaderförmige Kunststoffbeutel zur Aufnahme des Kühlmittels vorgesehen. Dabei liegt mindestens eine der großen Seitenwände nach Füllung mit dem Kühlmittel auf den zu kühlenden Bauelementen der Flachbaugruppe auf. Die Kunststoffbeutel weisen an einander gegenüberliegenden Schmalseiten Mündungen auf, die über Abzweigungen mit etwa in Zeilenrichtung verlaufenden Rohrleitungen für den Vorlauf und Rücklauf des Kühlmittels in Verbindung stehen. Die Kühlbeutel sind dabei jeweils zwischen zwei Flachbaugruppen fest in der Aufnahmevorrichtung für die Flachbaugruppen angeordnet.

Diese Art der Kühlung hat jedoch den Nachteil, daß bei Entnahme von Flachbaugruppen zum Zwecke der Prüfung oder der Reparatur die Kühlung der Flachbaugruppe nicht mehr gewährleistet ist, da der Kühlbeutel fest in der jeweiligen Aufnahmevorrichtung installiert ist. Außerdem kann bei Beschädigung des Kühlbeutels die Kühlflüssigkeit auf die Bauelemente einwirken und dort Schäden durch Korrosion bzw. durch Kurzschluß hervorrufen.

Aufgabe der vorliegenden Erfindung ist es, eine Kühlvorrichtung zu schaffen, die eine Kühlung der Flachbaugruppen auch im ausgebauten Zustand ermöglicht. Gleichzeitig sollen die Sicherheitsvorkehrungen bei Zerstörung eines Kühlbehälters erhöht werden.

Zur Lösung dieser Aufgaben wird die Kühlvorrichtung gemäß der Erfindung derart ausgebildet, daß jede Flachbaugruppe unmittelbar mit einem Kunststoffbehälter konstruktiv vereinigt ist, daß der Kunststoffbehälter aus einem Ober- und einem Unterteil aus dünnen flexiblen, elastischen und zerreißfesten, miteinander verschweißten Kunststofffolien besteht, daß an einem Ende der Längsseite dieses Kunststoffbehälters der Flüssigkeitszulauf über ein Rücksperrventil und am anderen Ende der Längsseite des Kunststoffbehälters der Flüssigkeitsablauf erfolgt, und daß auf der der Flachbaugruppe abgelegenen Seite des Kunststoffbehälters eine Abdeckplatte vorgesehen ist, die an der Flachbaugruppe mittels Schraubverbindungen befestigt ist.

Durch diese Maßnahmen wird eine intensive Kühlung sowohl im ein- als auch im ausgebauten Zustand der Flachbaugruppe gewährleistet. In der Aufnahmevorrichtung selbst sind keine besonderen konstruktiven Maßnahmen zur Aufnahme der Kühleinrichtung erforderlich.

Insbesondere kann die Kühlvorrichtung auch derart ausgebildet sein, daß der Kunststoffbehälter in mehrere untereinander angeordnete, mittels Schweißnähten voneinander getrennte Kanäle unterteilt ist.

Dadurch ist eine Bewegung des Kühlmittels im Gleichstrom- und/oder im Gegenstrombetrieb durch die Kanäle möglich.

Soll ein konstanter Geschwindigkeitsverlauf in den Kanälen erfolgen, dann ist es vorteilhaft, daß die Kanäle äquidistant zueinander angeordnet sind. Soll hingegen vom Zulauf her ein progressiver Geschwindigkeitsverlauf erzielt werden, so kann der Querschnitt der einzelnen Kanäle eine lineare Degression erhalten. Hauptgesichtspunkt für beide Arten der Kanalausführung ist der, daß wenig Oberflächenverlust durch die Fügenähte oder durch nichtdurchströmte Bereiche entsteht, da dort keine unmittelbare Kühlwirkung gegeben ist. Die Formung der Kanäle soll außerdem so vorgenommen sein, daß auch bei vertikaler Lage des Kühlkörpers Luftblasen nicht in der Strömung hängen bleiben können, also keine Hinterschneidungen der Kanäle in Stromrichtung vorkommen, sondern etwaige Luftblasen mitgerissen bzw. über Hilfskanäle abgesaugt werden.

Eine spezielle Form des Kühlkörpers ist die Ausbildung in eine mäanderförmige Form eines seriell durchströmten Hauptkanals. Anstelle der Kanäle tritt dann eine Schlauch- bzw. Rohrschlange.

Die Entlüftung kann dann mit Hilfe eines eigenen Entlüftungsschlauches erfolgen, der an den äußersten Stellen die Mäander ablaufseitig miteinander verbindet.

Zur Vermeidung von Zerstörungen durch Unebenheiten der Bauteile oder unterschiedliche Höhe derselben, kann auf der Flachbaugruppe ein Elastomerverguß aufgebracht werden, der wärmeleitend wirkt.

Der Kühlbehälter kann vorteilhafterweise flachbaugruppenseitig im Bereich der Fügenähte auch durch auf der Flachbaugruppe aufgebrachte Höcker abgestützt werden.

Zur Vermeidung von Schäden durch das auslaufende Kühlmittel bei eventueller Zerstörung eines Kühlbehälters, kann dieser in einem zusätzlichen, allseitig verschweißten, Überbeutel aus Kunststoff eingeschlossen sein.

Die Kühlbehälter können dabei aus einem völlig ebenen Flachbeutel oder einem bereits geöffneten bzw. vorgeformten Körper elastisch verformbar ausgebildet sein.

Eine andere Möglichkeit besteht darin, die Kühlkörper von einem völlig ebenen Flachbeutel oder einem bereits geöffneten bzw. vorgeformten Körper aus elastisch verformbar auszugestalten.

Als Folie kann auch eine Verbundfolie verwendet werden, die insbesondere auch eine Metallschicht enthält. Dadurch werden das Durchdiffundieren der Kühlflüssigkeit durch die Kunststoffwände der Folie und damit Korrosionsfehler vermieden und die Wärmeverteilung beginnt. Der Kühlbehälter kann auch aus mehreren Einzelfolien unterschiedlicher Wandstärken und Werkstoffe bestehen. Die den Bauteilen abgewandte Behälterwand kann auch aus einem massiven Werkstoff bestehen.

Jeweils mehreren Flachbaugruppen, die zu einem Flachbaugruppenkollektiv gehören, kann vorteilhafterweise ein Sicherheitsventil zugeordnet werden, das bei unzulässig hohem Druck die Kühlflüssigkeit unmittelbar ableitet. Dadurch wird die Wahrscheinlichkeit, daß ein Kühlbehälter bei überhöhtem Druck platzen kann und dadurch Schäden an der Flachbaugruppe anrichtet, weiter vermindert.

Unter jedem Flachbaugruppenkollektiv läßt sich ein Auffangbehälter für Kondensate vorsehen.

Die möglichen Schäden durch Diffusionsleckraten lassen sich weiter verringern dadurch, daß die Bausteinoberflächen mit Vertiefungen bzw. Dächern zum Dunstabzug versehen sind.

Eine andere Alternative besteht darin, daß die Bausteinoberfläche mittels einer metallischen Schutzschicht armiert ist. Dadurch wird eine Langzeitkorrosion ebenfalls vermieden.

Der Kühlbehälter und die Abdeckplatte lassen sich auch zu einer Montageeinheit vereinigen.

Eine Kondensation der Luftfeuchtigkeit kann dann eintreten, wenn die gekühlte Geräteeinheit geöffnet wird. Dies läßt sich dadurch vermeiden, daß unterhalb der Flachbaugruppen ein Heizgrill, ein Luftentfeuchter und Ventilatoren angeordnet sind, die bei geöffnetem Gehäuse in Tätigkeit treten.

Eine andere Möglichkeit besteht darin, daß bei geöffnetem Gehäuse die Dunstabzugskanäle auf den Flachbaugruppen durch schaltbare Blenden abdichtbar sind.

Diese Maßnahme ist vor allem dann vorteilhaft, wenn nur eine kurzzeitige Öffnung des Gehäuses vorgesehen wird.

Anhand der Ausführungsbeispiele nach den Figuren 1 bis 5 wird die Erfindung näher erläutert.

Figur 1 zeigt einen Kühlkörper, der in Kanäle unterteilt ist, wobei die Kanäle schlauchartig ausgebildet und in Mäanderform seriell hintereinander geschaltet sind.

Figur 2 zeigt die gleiche Ausführung nach Figur 1, jedoch mit einem zusätzlichen Überbeutel.

Figuren 3 und 4 zeigen einen als einfachsten Beutel ausgebildeten Kühlkörper.

Figur 5 zeigt ein systematisch dargestelltes Gehäuse mit Heizgrill, Kühlergrill und Ventilatoren.

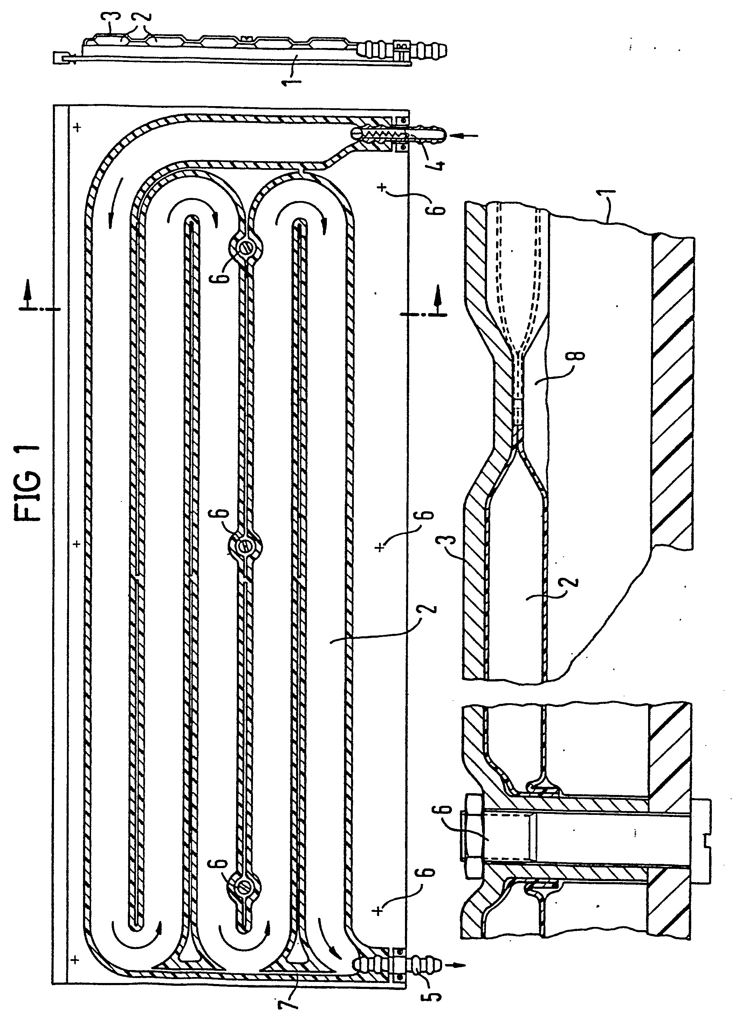

Figur 1 ist in eine Seitenansicht, eine Vordenansicht und eine Draufsicht unterteilt. Auf der Flachbaugruppe 1, die mit Bausteinen bestückt ist, liegt mit seiner einen Seite der Kühlbehälter 2, der aus einem Kunststofffolienoberteil und einem Kunststofffolienunterteil, die miteinander verschweißt sind, besteht, auf. Der Kühlbehälter ist dabei in mehrere Kanäle, die durch Schweißnähte voneinander getrennt sind, unterteilt, wobei die Kanäle seriell hintereinander geschaltet sind, so daß sie ein Mäandermuster ergeben. Die Kühlflüssigkeit wird über einen Stutzen, der auf der rechten Seite des Seitenrisses der Zeichnung dargestellt ist, über ein Rücksperrventil 4 den Kanälen zugeführt und durchfließt diese. Am entgegengesetzten Ende der Langseite dieses Kühlbehälters fließt die Flüssigkeit wieder ab. Auf der Abflußseite ist gleichzeitig der Entlüftungsschlauch 7 vorgesehen, der die einzelnen Mäander an ihrer äußersten Seite miteinander verbindet und dadurch einen Luftstau in diesem Bereich vermeidet.

Der Kühlbehälter ist auf der der Flachbaugruppe gegenüberliegenden Seite von einer Abdeckplatte 3 begrenzt.

Eine Einzelheit A ist in der Draufsicht unterhalb der Seitenansicht in Vergrößerung dargestellt. Dabei ist links ein flüssigkeitsgefüllter Kühlschlauch im Funktionszustand und rechts ein flüssigkeitsgefüllter Kühlschlauch vor der Druckbeaufschlagung gezeigt. Der Höcker 8 auf der Flachbaugruppe dient zur Abstützung des Kühlbehälters. Links daneben ist eine Schraubverbindung gezeigt, wobei zwischen zwei Fügenähten im Zwischenraum eine Schraube zur Befestigung mit der Flachbaugruppe vorgesehen ist.

Da der Aufbau nach der Erfindung zu einer Verformung von Leiterplatte und Abdeckplatte infolge der flächig verteilten Last führen kann, sind ausreichend viele derartige Befestigungspunkte zwischen Leiterplatte und Abdeckplatte vorzusehen, so daß sich keine Überschreitung zulässiger Spannungen und Verformungen ergibt.

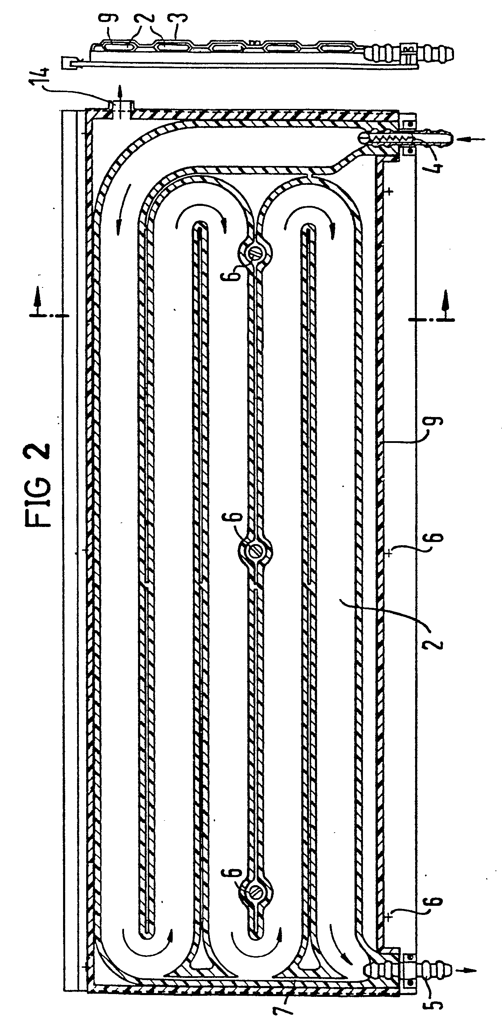

Figur 2 zeigt den gleichen Kühlbehälter, jedoch ist bei diesem zusätzlich ein Überbeutel 9, der auch einen Leckage-Ablaß 14 aufweisen kann, vorgesehen. Dadurch wird die Sicherheit noch weiter erhöht.

Soll eine Flachbaugruppe ausgetauscht werden, so ist zunächst der Zulauf speziell für diese Flachbaugruppe 1 durch Abklemmen zu unterbrechen. Der Kühlkörper wird infolge des absinkenden Druckes sich ganz oder teilweise über den Ablauf entleeren. Der Zulaufschlauch kann anschließend sofort abgezogen werden. Aus dessen Anschlußstutzen an der Flachbaugruppe 1 entweicht keine Flüssigkeit wegen des vorgesehenen Rücksperrventils 4. Beim Abziehen des Ablaufschlauches kann eventuell geringfügig Flüssigkeit aus dem zugehörigen Anschlußstutzen entweichen. Dort ist gegebenenfalls ein Verschlußstopfen vorzusehen. In diesem Zustand kann die Flachbaugruppe 1 transportiert werden. Der Zulauf- und der Ablaufschlauch werden bei entfernter Flachbaugruppe mit Schlauchklemmen verschlossen, so daß die Zuleitung des Kühlmittels für die übrigen Baugruppen nicht gestört ist.

Je einem Flachbaugruppenkollektiv ist dabei ein Sicherheitsventil, in der Zeichnung nicht dargestellt, zugeordnet, das die zulaufende Flüssigkeit bei einem gegebenen Überdruck sofort im Bypass ableitet.

Der Kühlbehälter kann an der Außenoberfläche eine besondere Schutzschicht durch Auswahl einer Verbundfolie bzw. Beschichtung oder Beklebung erhalten, um unter anderem ein Platzen durch starke Wärmeeinwirkung seitens eventueller abbrennender Bauteile oder scharfkantige Unebenheiten auf Extremfälle zu beschränken. Ein ebenfalls nicht dargestellter Auffangbehälter für die Flüssigkeit ist an der Unterseite eines jeden Flachbaugruppenkollektivs vorgesehen, um bei technischem oder menschlichem Versagen Schäden durch Flüssigkeit in Grenzen zu halten.

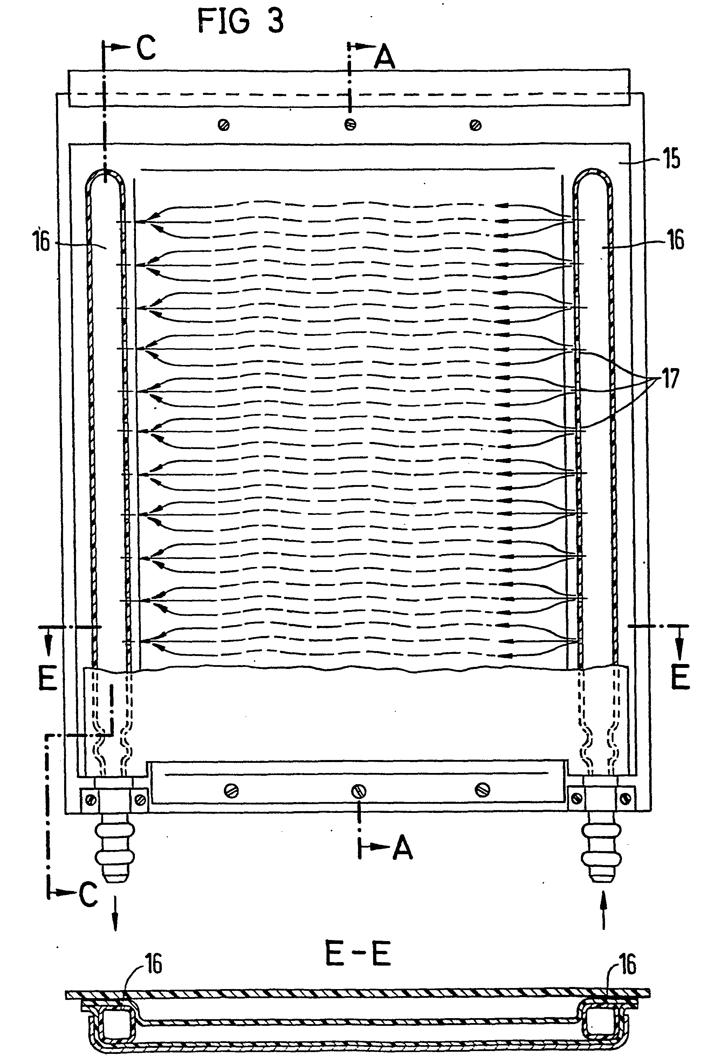

Der Kühlkörper nach Figur 3 besteht aus einem einfachen Beutel mit an seinen Schmalseiten angeordneten Verteilungskanälen, die rohrartig ausgebildet sind und die mit auf den Längsachsen versetzen Bohrungen versehen sind. Diese Bohrungen haben mit einem Expotentialverlauf sich verändernde Durchmesser, wobei die Veränderung ein- und auslaufseitig in umgekehrter Reihe erfolgt, so daß eine gleichmäßige Verteilung des Kühlmittels gewährleistet ist.

Dadurch lassen sich Schweißnähte im Inneren des Kühlkörpers, die zu einem ungenügend gekühlten Bereich führen können, vermeiden.

Um eine gleichmäßige Flüssigkeitsverteilung zu erreichen, kann man auch einen konstanten Durchmesser durch degressive Lochteilung oder ein konisches Rohr bzw. einen Schlitzkeil im Rohr des Stutzens vorsehen.

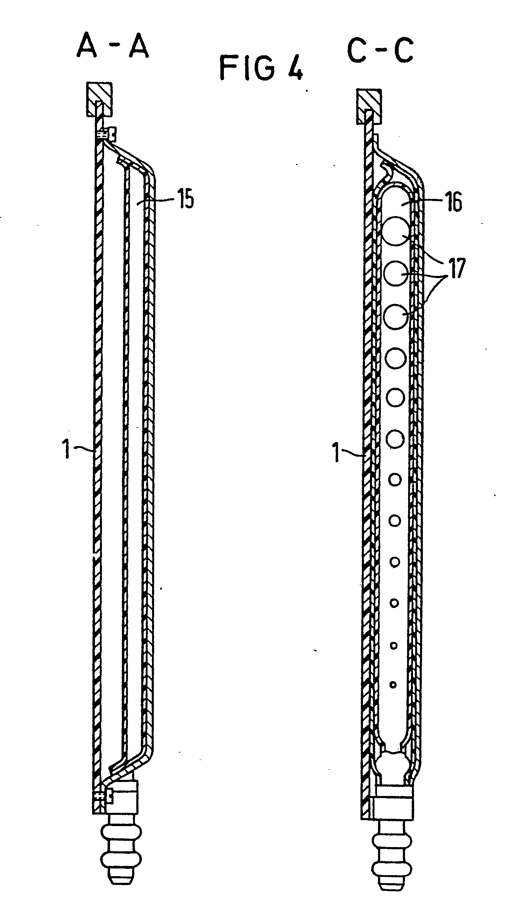

In Figur 4 ist ein Schnitt durch den Kühlkörper sowie ein Verteilungskanal mit exponentiell sich ändernden Öffnungsdurchmessern gezeigt.

Im allgemeinen wird bei einer Flachbaugruppe zwischen Bauteilseite und Lötseite unterschieden. Die Kühlkörper können dabei auf der Bauteile- und/oder der Lötseite der Flachbaugruppe angebracht sein.

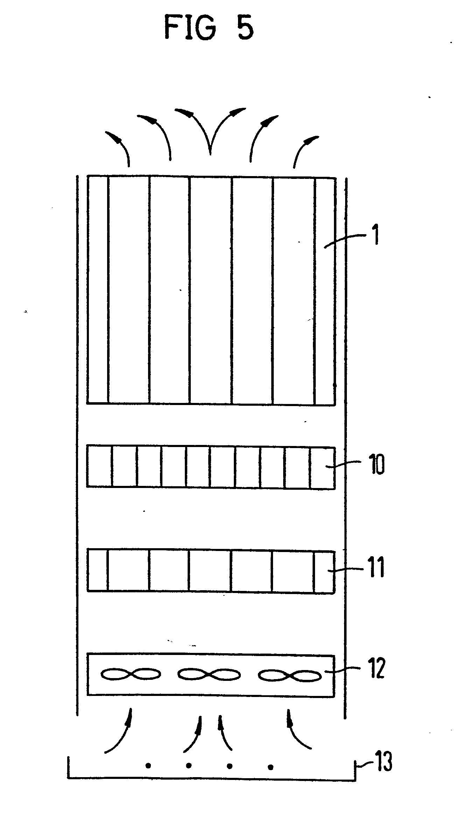

Figur 5 zeigt ein ganzes Gehäuse, bei dem neben dem zu einer Funktionseinheit vereinigten Flachbaugruppe 1 auch noch unterhalb dieser Funktionseinheit ein elektrisch beheizbarer Heizgrill 10, darunter ein Kühler 11 als Luftentfeuchter und darunter Ventilatoren 12 angeordnet sind. Unterhalb der Ventilatoren liegt der Kondensatauffangbehälter 13. Die Kühlertemperatur hat den niedrigsten Temperaturwert des Gehäuses.

Bei Gehäuseöffnung treten der Heizgrill, der Kühler sowie die Ventilatoren in Tätigkeit, wodurch die einströmende Umgebungsluft entfeuchtet wird und ungesättigt in die Verdunstungskanäle der Flachbaugruppen der Funktionseinheit eintritt. Dadurch kann eine erneute Kondensation an den Flachbaugruppenkühlkörpern bei gleichzeitiger Aufrechterhaltung der Verdunstung kaum noch auftreten.

Eine andere Möglichkeit, die jedoch in der Zeichnung nicht eigens dargestellt ist, besteht darin, die Verdunstungskanäle bei Öffnen des Gehäuses durch schaltbare Abschlüsse zu schließen. Diese Ausführung ist zwar einfach, jedoch nur bei kurzem Öffnen der Gehäuse vorteilhaft. Durch diese letztgenannten Ausführungen lassen sich hohe, mittlere fehlerfreie Betriebszeiten erreichen.

Außerdem wird dadurch erreicht, daß man nicht erst eine Wartezeit zum Hochfahren der Innentemperatur im Gehäuse in Kauf nehmen muß, bevor dieses geöffnet wird.

**Ansprüche**

1. Kühlvorrichtung zur Kühlung von elektrischen Bauelementen, insbesondere von integrierten Bausteinen, die auf mit ihren Flachseiten nebeneinander angeordneten, vorzugsweise steckbaren Flachbaugruppen aufgebaut sind, mit einem flüssigen Kühlmittel, das durch dünnwandige Kunststoffbehälter geführt wird, die mit einer der Seitenwände an der zu kühlenden Flachbaugruppenoberfläche anliegen, wobei der Kreislauf außerhalb der Baueinheit zur Aufnahme der Flachbaugruppe über gemeinsame Sammelrohrleitungen, eine Pumpe, einen Kühler für die Rückkühlung des Kühlmittels und einem Vorratsbehälter geschlossen ist, dadurch gekennzeichnet, daß jede Flachbaugruppe (1) unmittelbar mit mindestens einem Kunststoffbehälter (2) konstruktiv vereinigt ist, daß der Kunststoffbehälter (2) aus einem Ober- und einem Unterteil aus dünnen, flexiblen, elastischen und zerreißfesten, z.B. miteinander verschweißten Kunststoffolien besteht, daß an einem Ende der Längsseite dieses Kunststoffbehälters (2) der Flüssigkeitszulauf (4) und am anderen Ende der Längsseite des Kunststoffbehälters (2) der Flüssigkeitsablauf erfolgt und daß auf der der Flachbaugruppe (1) abgelegenen Seite des Kunststoffbehälters (2) eine Abdeckplatte (3) vorgesehen ist, die an der Flachbaugruppe (1) mittels Befestigungselementen (6) angebracht ist.

2. Kühlvorrichtung nach Anspruch 1, dadurch gekennzeichnet, daß der Kunststoffbehälter (2) in mehrere untereinander angeordnete, mittels Schweißnähten voneinander getrennte Kanäle unterteilt ist.

3. Kühlvorrichtung nach Anspruch 2, dadurch gekennzeichnet, daß die Kanäle äquidistant zueinander angeordnet sind.

4. Kühlvorrichtung nach Anspruch 2, dadurch gekennzeichnet, daß die Kanalquerschnitte eine Degression aufweisen.

5. Kühlvorrichtungen nach einem der vorhergehenden Ansprüche, dadurch gekennzeichnet, daß die Kanäle so miteinander verbunden sind, daß sich eine mäanderförmige Form eines seriell durchströmten Hauptkanals ergibt.

6. Kühlvorrichtung nach Anspruch 5, dadurch gekennzeichnet, daß der Kunststoffbehälter (2) aus einer Schlauch- bzw. Rohrschlange aus Kunststoff besteht.

7. Kühlvorrichtung nach einem der vorhergehenden Ansprüche, dadurch gekennzeichnet, daß Hilfskanäle zum Absaugen von Luftblasen vorgesehen sind.

8. Kühlvorrichtung nach Anspruch 6, dadurch gekennzeichnet, daß die Mäander ablaufseitig jeweils an der äußersten Stelle über einen Entlüftungsschlauch (7) miteinander verbunden sind.

9. Kühlvorrichtung nach einem der vorhergehenden Ansprüche, dadurch gekennzeichnet, daß durch Bauteile unterschiedlicher Höhe verursachte Unebenheiten durch eine wärmeleitende Isolierstoffmasse, z.B. Elastomer, ausgeglichen werden.

10. Kühlvorrichtung nach Anspruch 9, dadurch gekennzeichnet, daß die Kunststoffbehälter (2) flachbaugruppenseitig im Bereich der Fügenähte durch auf der Flachbaugruppe (1) aufgebrachte Höcker (8) abgestützt sind.

11. Kühlvorrichtung nach einem der vorhergehenden Ansprüche, dadurch gekennzeichnet, daß der Kühlbehälter in mindestens einem zusätzlichen, allseitig verschweißten Überbeutel (9) aus Kunststoff eingeschlossen ist.

12. Kühlvorrichtung nach einem der hervorgehenden Ansprüche, dadurch gekennzeichnet, daß der Überbeutel einen Ablaß aufweist.

13. Kühlvorrichtung nach einem der vorhergehenden Ansprüche, dadurch gekennzeichnet, daß die Kühlbehälter dabei einen völlig ebenen Flachbeutel oder einen bereits geöffneten bzw. vorgeformten Körper aus reversibel elastisch verformbar ausgebildet sein können.

14. Kühlvorrichtung nach einem der Ansprüche 1 bis 11, dadurch gekennzeichnet, daß die Kühlbehälter von einem völlig ebenen Flachbeutel oder einem bereits geöffnetem bzw. vorgeformten Körper aus elastisch plastisch verformbar sind.

15. Kühlvorrichtung nach einem der vorhergehenden Ansprüche, dadurch gekennzeichnet, daß als Kunststofffolie eine Verbundfolie verwendet ist, die insbesondere auch mindestens eine Metallschicht enthält.

16. Kühlvorrichtung nach einem der vorhergehenden Ansprüche, dadurch gekennzeichnet, daß der Kühlbehälter aus mehreren Einzelfolien pro Seitenwand besteht.

17. Kühlvorrichtung nach einem der vorhergehenden Ansprüche, dadurch gekennzeichnet, daß der Flüssigkeitszulauf über ein Rücksperrventil erfolgt.

18. Kühlvorrichtung nach einem der vorhergehenden Ansprüche, dadurch gekennzeichnet, daß jeweils mehrere Flachbaugruppen (Flachbaugruppenkollektiv) ein Sicherheitsventil zugeordnet ist, das bei unzulässig hohem Druck die Kühlflüssigkeit unmittelbar ableitet.

19. Kühlvorrichtung nach einem der vorhergehenden Ansprüche, dadurch gekennzeichnet, daß unter jedem Flachbaugruppenkollektiv ein Auffangbehälter vorgesehen ist.

20. Kühlvorrichtung nach einem der vorhergehenden Ansprüche, dadurch gekennzeichnet, daß die Bausteinoberflächen mit Vertiefungen bzw. Dächern zum Dunstabzug versehen sind.

21. Kühlvorrichtung nach einem der vorhergehenden Ansprüche, dadurch gekennzeichnet, daß die gekühlte Flachbaugruppenoberfläche mittels einer Schutzschicht armiert ist.

22. Kühlvorrichtung nach einem der vorhergehenden Ansprüche, dadurch gekennzeichnet, daß der Kühlkörper mit einer Schutzschicht armiert ist.

23. Kühlvorrichtung nach einem der vorhergehenden Ansprüche, dadurch gekennzeichnet, daß Kühlbehälter (2) und Abdeckplatte (3) zu einer Kühlbaugruppe vereinigt sind.

24. Kühlvorrichtung nach einem der vorhergehenden Ansprüche, dadurch gekennzeichnet, daß unterhalb der Flachbaugruppen (1) ein Heizgrill (10), ein Entfeuchter (11) und Ventilatoren (12) angeordnet sind, die bei geöffnetem Gehäuse in Tätigkeit treten.

25. Kühlvorrichtung nach einem der Ansprüche 1 bis 21, dadurch gekennzeichnet, daß bei geöffnetem Gehäuse die Entlüftungskanäle auf den Flachbaugruppen (1) durch schaltbare Blenden abdichtbar sind.

26. Kühlvorrichtung nach Anspruch 1, dadurch gekennzeichnet, daß der Kühlkörper aus einem einfachen Beutel (15) mit an seinen Schmalseiten angeordneten Verteilungskanälen (16) besteht, die rohrartig ausgebildet sind und die mit auf den Längsachsen der Verteilungskanäle versetzten Bohrungen (17) versehen sind, daß die Durchmesser der Bohrungen (17) sich fortlaufend nach einem Exponentialverlauf ändern, wobei die Veränderung ein- und auslaufseitig in umgekehrter Reihe erfolgt.

27. Kühlvorrichtung nach Anspruch 1, dadurch gekennzeichnet, daß der Kühlkörper aus einem einfachen Beutel (15) mit an seinen Schmalseiten angeordneten Verteilungskanälen (16) besteht, die rohrartig ausgebildet sind und die mit auf den Längsachsen der Verteilungskanäle versetzten Bohrungen (17) versehen sind, daß die Durchmesser der Bohrungen (17) gleich groß, deren Abstände voneinander aber degressiv sind.

28. Kühlvorrichtung nach Anspruch 1, dadurch gekennzeichnet, daß der Kühlkörper aus einem einfachen Beutel (15) mit an seinen Schmalseiten angeordneten Verteilungskanälen (16) besteht, die rohrartig ausgebildet sind und die mit auf den Längsachsen der Verteilungskanäle versetzten Bohrungen (17) versehen sind, daß die Durchmesser der Bohrungen (17) und deren Abstände gleich groß, die rohrartigen Verteilungskanäle aber konisch ausgebildet sind.

29. Kühlvorrichtung nach Anspruch 1, dadurch gekennzeichnet, daß der Kühlkörper aus einem einfachen Beutel (15) mit an seinen Schmalseiten angeordneten Verteilungskanälen (16) besteht, die rohrartig ausgebildet sind und die mit auf den Längsachsen der Verteilungskanäle keilförmig sich erweiternden Schlitzen versehen sind.

## Claims

1. A cooling arrangement for cooling electrical components, in particular integrated modules, which are formed on flat assemblies (preferably plug-in assemblies), the flat sides of which are arranged one beside another said arrangement comprising a liquid coolant which is passed through thin-walled synthetic containers which are arranged with one of their side walls in contact with the surface of the flat assembly which is to be cooled, and wherein a closed circuit is formed outside the unit serving to accommodate the flat assembly, by way of common collector pipes, a pump, a cooler for recooling the coolant, and a storage container, characterised in that each flat assembly (1) is directly structurally combined with at least one synthetic resin container (2) ; that the synthetic resin container (2) consists of upper and lower parts consisting of thin, flexible, elastic and tear-resistant synthetic resin films which are, for example, welded to one another ; that the inflow of liquid (4) takes place at one end of the long side of said synthetic resin container (2) and the liquid outflow at the other end thereof ; and that on that side of the synthetic resin container (2) which is remote from the flat assembly (1), there is arranged a cover plate (3) which is attached to the flat assembly (1) by means of fastening elements (6).

2. A cooling arrangement as claimed in Claim 1, characterised in that the synthetic resin container (2) is divided into a plurality of channels which are arranged one below another and are separated from one another by weld seams.

3. A cooling arrangement as claimed in Claim 2, characterised in that the channels are arranged equidistantly from one another.

4. A cooling arrangement as claimed in Claim 2, characterised in that the channel cross-sections exhibit a progressive decrease.

5. Cooling arrangements as claimed in one of the preceding Claims, characterised in that the channels are connected to one another so as to produce a serpentine formation forming a main channel which the coolant flows through in serial fashion.

6. A cooling arrangement as claimed in Claim 5, characterised in that the synthetic resin container (2) consists of a serpentine formation of piping or tubing made of synthetic resin.

7. A cooling arrangement as claimed in one of the preceding Claims, characterised in that auxiliary channels are provided for sucking away air bubbles.

8. A cooling arrangement as claimed in Claim 6, characterised in that, at the outflow end, the serpentine formations are each connected to one another at the outermost point by way of a ventilating tube (7).

9. A cooling arrangement as claimed in one of the preceding Claims, characterised in that irregularities caused by components of differing heights are compensated for by a heat-conducting insulating mass, e.g. of an elastomer.

10. A cooling arrangement as claimed in Claim 9, characterised in that at the side of the flat assemblies, in the region of the joining seam, the synthetic resin containers (2) are supported by protuberances (8) arranged on the flat assembly (1).

11. A cooling arrangement as claimed in one of the preceding Claims, characterised in that the cooling container is enclosed in at least one additional synthetic resin outer bag (9) which is welded all round.

12. A cooling arrangement as claimed in one of the preceding Claims, characterised in that the outer bag has an outlet.

13. A cooling arrangement as claimed in one of the preceding Claims, characterised in that the cooling containers can be formed so as to be reversibly elastically deformable, from a completely level flat bag or from an already opened or preformed body.

14. A cooling arrangement as claimed in one of Claims 1 to 11, characterised in that the cooling containers can be elastically and plastically deformed from a completely flat bag or from an already opened or preformed body.

15. A cooling arrangement as claimed in one of the preceding Claims, characterised in that a compound film which, in particular, contains at least one metal layer, is used as the synthetic resin film.

16. A cooling arrangement as claimed in one of the preceding Claims, characterised in that the cooling container consists of a plurality of individual films in respect of each side wall.

17. A cooling arrangement as claimed in one of the preceding Claims, characterised in that the inflow of liquid takes place through a non-return valve.

18. A cooling arrangement as claimed in one of the preceding Claims, characterised in that several flat assemblies (flat assembly group) are allotted a safety valve which at an impermissibly high pressure, directly diverts the cooling liquid.

19. A cooling arrangement as claimed in one of the preceding Claims characterised in that a collecting vessel is arranged below each flat assembly group.

20. A cooling arrangement as claimed in one of the preceding Claims, characterised in that the module surfaces are provided with recesses or grooves for the removal of vapour.

21. A cooling arrangement as claimed in one of the preceding Claims, characterised in that the cooled flat assembly surface is shielded by a protective layer.

22. A cooling arrangement as claimed in one of the preceding Claims, characterised in that the cooling body is shielded by a protective layer.

23. A cooling arrangement as claimed in one of the preceding Claims, characterised in that the cooling container (2) and a cover plate (3) are combined to form a cooling assembly.

24. A cooling arrangement as claimed in one of

the preceding Claims, characterised in that beneath the flat assemblies (1), there are arranged a heater grill (10), a desiccator (11) and ventilators (12), which come into operation when the housing is open.

25. A cooling arrangement as claimed in one of Claims 1 to 21, characterised in that, when the housing is open, the deaeration channels on the flat assemblies (1) can be sealed by means of switchable shutters.

26. A cooling arrangement as claimed in Claim 1, characterised in that the cooling body consists of a simple bag (15) provided with distribution channels (16) arranged on its narrow sides, which are of tubular form and which are provided with bores (17) offset from the longitudinal axes of the distribution channels ; and that the diameters of the bores (17) vary continuously in accordance with an exponential curve, the variation taking place in opposite senses at the inflow and outflow ends.

27. A cooling arrangement as claimed in Claim 1, characterised in that the cooling body consists of a simple bag (15) provided with distribution channels (16) arranged on its narrow sides, which are of tubular form and which are provided with bores (17) offset from the longitudinal axes of the distribution channels ; and that the diameters of the bores (17) are of the same value but the intervals between the bores progressively decrease.

28. A cooling arrangement as claimed in Claim 1, characterised in that the cooling body consists of a simple bag (15) with distribution channels (16) which are arranged on its narrow sides, which are of tubular form and which are provided with bores (17) offset from the longitudinal axes of the distribution channels ; and that the diameters of the bores (17) and the intervals between said bores are of equal size, but the tubular distribution channels are of conical form.

29. A cooling arrangement as claimed in Claim 1, characterised in that the cooling body consists of a simple bag (15) with distribution channels (16) which are arranged on its narrow sides, which are of tubular formation, and which are provided with slots which expand in tapered fashion on the longitudinal axes of the distribution channels.

## Revendications

1. Dispositif de refroidissement pour refroidir des composants électriques, plus particulièrement des modules constitués de préférence par des groupes de sous-ensembles plats enfichables disposés côte à côte par leurs côtés plats, avec un agent réfrigérant qui est guidé à travers des réservoirs en matière plastique à parois minces et qui par une des parois latérales portent contre la surface des groupes de sous-ensembles plats enfichables à refroidir, le circuit étant fermé en dehors de l'unité de construction par l'intermédiaire de collecteurs communs, par une pompe, par un radiateur pour le refroidissement de l'agent réfrigérant et par un réservoir de réserve, caractérisé par le fait que chaque groupe de sous-ensembles plat enfichable (1) est réuni, directement ou par construction, à un réservoir de matière plastique (2), que le réservoir en matière plastique (2) est constitué par une partie supérieure et une partie inférieure faites avec des feuilles de matière plastique minces, souples, élastiques et résistant à la rupture, soudées, par exemple, entre elles, qu'à une extrémité du côté longitudinal de ce réservoir en matière plastique (2) se trouve l'entrée du liquide (4) et à l'autre extrémité du côté longitudinal du réservoir en matière plastique (2) la sortie du liquide, et qu'il est prévu sur le côté du réservoir en matière plastique (2), qui est éloigné du groupe de sous-ensembles plat un couvercle (3) monté sur ledit groupe (1) au moyen d'éléments de fixation (6).

2. Dispositif de refroidissement selon la revendication 1, caractérisé par le fait que le réservoir en matière plastique (2) est subdivisé en plusieurs canaux disposés les uns sur les autres et séparés entre eux.

3. Dispositif de refroidissement selon la revendication 2, caractérisé par le fait que les canaux sont équidistants entre eux.

4. Dispositif de refroidissement selon la revendication 2, caractérisé par le fait que la section transversale des canaux est dégressive.

5. Dispositif de refroidissement selon l'une des revendications antérieures, caractérisé par le fait que les canaux sont reliés de telle façon entre eux qu'il en résulte un canal principal en forme de méandres traversés en série par l'agent réfrigérant.

6. Dispositif de refroidissement selon la revendication 5, caractérisé par le fait que le réservoir en matière plastique (2) est constitué par un serpentin formé par un tube souple ou par un tuyau en matière plastique.

7. Dispositif de refroidissement selon l'une des revendications antérieures, caractérisé par le fait que l'on prévoit des canaux auxiliaires pour aspirer les bulles d'air.

8. Dispositif de refroidissement selon la revendication 6, caractérisé par le fait que du côté de l'évacuation, les méandres sont reliés entre eux, aux emplacements extérieurs, au moyen d'un tube d'évacuation de l'air (7).

9. Dispositif de refroidissement selon l'une des revendications antérieures, caractérisé par le fait que des inégalités de surfaces, qui sont dues à des hauteurs différentes d'éléments de construction, sont compensées par une masse isolante thermoconductrice, par exemple par un élastomère.

10. Dispositif de refroidissement selon la revendication 9, caractérisé par le fait que le réservoir en matière plastique (2) est soutenu, du côté du groupe de sous-ensembles plat, au niveau des cordons de soudure et d'assemblage, par des bosses (8) portées par le groupe de sous-ensembles plat (1).

11. Dispositif de refroidissement selon l'une des revendications antérieures, caractérisé par le fait que le réservoir de refroidissement est enfermé dans au moins un sachet extérieur supplémentaire (9) qui est soudé sur tous ses côtés et qui est constitué avec une matière plastique.

12. Dispositif de refroidissement selon l'une des revendications antérieures, caractérisé par le fait que le sachet extérieur comporte un évent.

13. Dispositif de refroidissement selon l'une des revendications antérieures, caractérisé par le fait que les réservoirs de refroidissement peuvent être constitués par des sachets plans complètement plats ou par des corps déjà ouverts ou préformés en un matériau élastiquement déformable de façon réversible.

14. Dispositif de refroidissement selon l'une des revendications 1 à 11, caractérisé par le fait que les réservoirs de refroidissement sont susceptibles d'être déformés par un sachet plat entièrement plan ou par un corps déjà ouvert ou préformé en un matériau plastiquement élastique.

15. Dispositif de refroidissement selon l'une des revendications antérieures, caractérisé par le fait qu'on utilise comme feuille de matière plastique une feuille complexe qui, en particulier, comporte également au moins une couche métallique.

16. Dispositif de refroidissement selon l'une des revendications antérieures, caractérisé par le fait que le réservoir de refroidissement est constitué par plusieurs feuilles individuelles par parois latérales.

17. Dispositif de refroidissement selon l'une des revendications antérieures, caractérisé par le fait que l'admission du liquide est opérée par l'intermédiaire d'une soupape de retenue.

18. Dispositif de refroidissement selon l'une des revendications antérieures, caractérisé par le fait qu'à chacun de plusieurs groupes de sous-ensembles plats (ensemble de groupes de sous-ensembles plats) est associée une soupape de sécurité qui dérive directement le liquide de refroidissement pour une pression de valeur inadmissible.

19. Dispositif de refroidissement selon l'une des revendications antérieures, caractérisé par le fait que sous chaque ensemble de groupes de sous-ensembles plats est prévu un réservoir-collecteur.

20. Dispositif de refroidissement selon l'une des revendications antérieures, caractérisé par le fait que des surfaces des modules sont pourvues de cuvettes ou dépressions ou de toits pour l'évacuation de la vapeur.

21. Dispositif de refroidissement selon l'une des revendications antérieures, caractérisé par le fait que la surface refroidie des groupes de sous-ensembles plats est armée d'une couche de protection.

22. Dispositif de refroidissement selon l'une des revendications antérieures, caractérisé par le fait que le corps de refroidissement est armé d'une couche de protection.

23. Dispositif de refroidissement selon l'une des revendications antérieures, caractérisé par le fait que le réservoir de refroidissement (2) et le couvercle (3) sont réunis pour former un groupe d'un ensemble de refroidissement.

24. Dispositif de refroidissement selon l'une des revendications antérieures, caractérisé par le fait qu'en dessous des groupes de sous-ensembles plats (1) est disposée une grille chauffante (10), un déshumidificateur (11) et des ventilateurs (12) qui entrent en action lorsque le boîtier est ouvert.

25. Dispositif de refroidissement selon l'une des revendications 1 à 21, caractérisé par le fait que lorsque le boîtier est ouvert, les canaux de désaération prévus sur les groupes de sous-ensembles plats (1) sont susceptibles d'être rendus étanches au moyen de diaphragmes commutables.

26. Dispositif de refroidissement selon la revendication 1, caractérisé par le fait que le corps de refroidissement est constitué par un simple sachet (15) à canaux de répartition (16) disposés sur ses côtés étroits, canaux de répartition qui ont la forme de tubes et qui sont pourvus de perçages (17) décalés le long des axes des canaux de répartition, que les diamètres des perçages (17) varient de façon continue suivant une allure exponentielle et que la variation a lieu dans l'ordre inverse du côté entrée et du côté sortie.

27. Dispositif de refroidissement selon la revendication 1, caractérisé par le fait que le corps de refroidissement est constitué par un simple sachet (15) à canaux de répartition (16) disposés sur ses côtés étroits, canaux de répartition qui ont la forme de tubes et qui sont pourvus de perçages (17) décalés le long des axes longitudinaux des canaux de répartition, et que les diamètres des perçages (17) sont identiques, leur distance réciproque étant dans le sens dégressif.

28. Dispositif de refroidissement selon la revendication 1, caractérisé par le fait que le corps de refroidissement est constitué par un simple sachet (15) à canaux de répartition (16) disposés sur ses côtés étroits, lesdits canaux de répartition étant réalisés sous la forme de tuyaux qui sont pourvus de perçages (17) décalés le long des axes longitudinaux desdits canaux, et que les diamètres des perçages (17) et leur distance sont de même valeur alors que les canaux de répartition de forme tubulaire ont une forme conique.

29. Dispositif de refroidissement selon la 1, caractérisé par le fait que le corps de refroidissement est constitué par un simple sachet (15) à canaux de répartition (16) disposés sur ses côtés étroits, lesdits canaux de répartition ayant la forme de tuyaux qui sont pourvus sur leurs axes longitudinaux de fentes qui s'élargissent de façon cunéiforme.

# FIG 1

0014 249

FIG **2**

0014 249

0 014 249

# FIG 3

E-E

3

A - A    FIG 4    C - C

# FIG 5